# EUROPEAN PATENT APPLICATION

(11) **EP 4 734 373 A1**
(43) Date of publication of application: **29.04.2026**
(21) Application number: 24208899.5
(22) Date of filing: 25.10.2024
(51) Int. Cl.: H03K 17/72, H03K 17/687

(54) **ELECTRONIC CIRCUIT AND METHOD OF OPERATING AN ELECTRONIC CIRCUIT**

(71) Applicant: Hitachi Energy Ltd, 8050 Zürich (CH)
(72) Inventor: WALTISBERG, Christoph, 5103 Möriken (CH); WIDMER, Manuel, 6020 Emmenbrücke (CH)
(74) Representative: Epping - Hermann - Fischer

(57) **Abstract**

An electric circuit (1) comprising a power thyristor (2) device (2) is specified, wherein
- a gate (21) of the power thyristor device (2) is connected to an internal reference (10) of the electric circuit (1) via a first switch (31); and
- a cathode (22) of the power thyristor device (2) is connected to the internal reference (10) of the electric circuit (1) via a second switch (32).

Further, a method of operating an electric circuit (1) is specified.

## Description

The present disclosure relates to an electric circuit and to a method of operating an electric circuit.

Thyristors are well-suited for power applications as they can be used to switch electrical signals with high electric currents and/or high voltages.

Embodiments of the disclosure relate to a way to improve the capabilities of an electric circuit comprising a thyristor device.

According to an embodiment, an electric circuit comprises a power thyristor device wherein a gate of the power thyristor device is connected to an internal reference of the electric circuit via a first switch. A cathode of the power thyristor device is connected to the internal reference of the electric circuit via a second switch.

Thus, the gate is electrically connected to the cathode if the first switch and the second switch are in an electrically conductive on-state. By means of the first switch and the second switch, it can be ensured that a blocking capability of the power thyristor device is maintained all the time. In particular, the blocking capability can be maintained during a starting mode and during a shutdown or failure mode of the electric circuit.

During regular operation of the electric circuit, the first switch and/or the second switch can be brought into an electrically non-conducting off-state (or blocking state) so that there is no low-impedance interconnection between the cathode and the gate of the power thyristor device.

For example, the power thyristor device is configured to be operated at high electric currents of at least 100 A and/or at high voltages of at least 1000 V.

The internal reference of the electric circuit is in particular the power level that all power supply voltages of the electric circuit refer to. In particular, there may be both positive and negative voltage levels with respect to the internal reference. The internal reference may be at ground potential or be separated from ground potential.

According to a further embodiment of the electric circuit, the power thyristor device is a gate-commutated thyristor.

A gate-commutated thyristor can be switched on and off by a gate signal applied to the gate of the gate-commutated thyristor.

According to a further embodiment of the electric circuit, the first switch and/or the second switch are semiconductor devices. Semiconductor devices can provide exceptionally reliable switches as they are insensitive to vibrations. In particular, they are less susceptible to vibrations than relays.

In particular, the first switch and/or the second switch may be normally-on semiconductor devices. Thus, the first switch and/or the second switch are electrically conductive if no voltage is applied to the respective gate.

If both the first switch and the second switch are normally-on semiconductor devices, the electric circuit provides an electrical connection between the cathode and the gate of the power thyristor device in case that no voltage is applied to the gates of these switches. This helps to ensure full blocking capability of the power thyristor device if the gate of the power thyristor device is unpowered.

According to a further embodiment of the electric circuit, the first switch and the second switch are depletion mode n-channel field-effect transistors such as metal oxide semiconductor field-effect transistors (MOSFETs). This type of transistors is electrically conductive if no voltage is applied to its gate.

By applying a negative voltage between the gate and the source of the transistor, the depletion mode n-channel field-effect transistor can be turned off.

According to a further embodiment of the electric circuit, a resistor configured to limit a discharge current is arranged in a current path through the second switch between the cathode and the internal reference. By means of the resistor, a discharge current during a shutdown of the electric circuit may be limited. For example, the resistor is arranged between the cathode and the second switch. For example, a resistance of the resistor is at least 0.1 Ω or at least 1 Ω. Alternatively or in addition, the resistance may be at most 30 Q or at most 20 Q or at most 7 Q. Alternatively or in addition, a gate voltage of the second switch may be controlled to limit the discharge current. In this case, the resistor may be dispensed with or used as a shunt resistor.

According to a further embodiment of the electric circuit, the electric circuit further comprises a gate control unit configured to control the gate of the power thyristor, the first switch and the second switch. The gate control unit may provide one or more power supplies, in particular with different voltage levels, and/or a monitor and control logic and/or drivers and/or trigger circuits and/or back porch circuits or further active or passive components. For example, the gate control unit is configured to provide different pulse patterns during different operation modes. In other words, the electric circuit is configured to be operable in a plurality of operation modes.

According to a further embodiment of the electric circuit, the electric circuit is configured as an integrated gate-commutated thyristor (IGCT). An IGCT in particular comprises a power thyristor device and a gate unit to control the power thyristor device.

In contrast to a conventional IGCT, however, the first switch and the second switch of the electric circuit can be used to provide a high DC blocking and/or dV/dt robustness in all operation modes, in particular even if the IGCT is unpowered or if the gate voltage is off.

According to a further embodiment of the electric circuit, the electric circuit further comprises a capacitor unit connected to the gate via a third switch. In particular the capacitor unit is configured to provide a switch-off current to the gate of the thyristor device. For example, the capacitor unit comprises a plurality of capacitors electrically connected in parallel.

For example, the gate control unit is configured to control the third switch.

According to a further embodiment of the electric circuit, the third switch comprises a normally-off semiconductor device. For example, the third switch comprises a plurality of semiconductor devices electrically connected in parallel.

For example, the normally-off semiconductor device is an enhancement-mode field effect transistor. Thus, the capacitor unit is partly discharged if the third switch is brought into its on-state as long as there is a charge in the thyristor device. In other words, the charge drawn from the capacitor unit is equal to or at least substantially equal to the charge between gate and cathode inside the thyristor device.

Further, the capacitor unit can be discharged if the second switch is in its on-state, for example via the resistor.

The electric circuit may be configured to be operable in different operation modes such as a starting mode and/or a regular operation mode and/or a shutdown or failure mode.

During all of these operation modes, a full blocking capability of the power thyristor device can be ensured, in particular by means of a pulse pattern that provides an electric short-circuit between the gate and the cathode of the power thyristor device when required.

Further, a method of operating an electric circuit as described above is specified.

According to an embodiment of the electric circuit, the electric circuit is operated in a starting mode wherein the first switch is brought in an off-state after the capacitor has been charged. In particular, the second switch is already in the off-state at the time where the first switch is brought in the off-state.

After the first switch has been brought in the off-state, the electric circuit can be operated in the regular operation mode. In the regular operation mode, the power thyristor device can be turned on and off by applying an appropriate signal to the gate of the power thyristor device.

According to a further embodiment of the method, the second switch is brought in an off-state before the first switch is brought in an off-state. In particular, the second switch may be brought in the off-state before the capacitor unit is charged.

During the starting mode, the on-state of the first switch ensures the blocking capability of the power thyristor device. During regular operation, the power thyristor device can be switched off by partly discharging the capacitor unit via the third switch. The charge drawn from the capacitor unit may be equal to or at least substantially equal to the charge between gate and cathode inside the thyristor device. Further, the thyristor device can be turned on when a signal is applied from the gate control unit to the gate of the thyristor device.

According to a further embodiment of the method, the electric circuit is operated in a shutdown or failure mode, wherein the first switch and the second switch are brought in an on-state at a time where the capacitor unit is at least partly discharged.

At the beginning of the discharging process, the capacitor unit may provide sufficient electric power to operate the gate control unit. If the power decreases it is no longer sufficient to maintain or to deliver a back porch current or to turn on the power thyristor device. In this case the gate unit will no longer react in response to input signals.

If the power thyristor device is in its on-state, the gate control unit will turn off the power thyristor device by turning on its off-channel via the third switch.

Further, the first switch will be brought in its conducting state, thereby electrically connecting the gate to the internal reference.

Further, the second switch is brought in its on-state, thereby connecting the cathode to the internal reference. This may happen prior, during to or slightly after a power loss of the control logic of the gate control unit. In this state, the remaining charge in the capacitor unit is discharged.

According to a further embodiment of the method, the first switch is brought in the on-state prior to the second switch during the shutdown or failure mode.

Thus, the gate is connected to the internal reference prior to the cathode.

By means of an appropriate pulse pattern, the method allows to ensure good DC blocking capabilities and a high dV/dt robustness in all operation modes of the electric circuit. In particular, a reliable blocking behaviour of the power thyristor device can be ensured if the electric circuit is unpowered and/or if there is no voltage applied to the gate.

Further, the electric circuit is black start capable. This means in particular that an unpowered gate of the power thyristor device is capable to withstand at least voltage ramps with a slope of 100 vips.

Thus, the first and second switch ensure that a low impedance connection is provided between the gate and the cathode of the power thyristor device under the condition that the gate is not powered. In particular, the black start capability does not require any electrical power or any kind of energy storage.

For example, the electric circuit may be configured for a high voltage direct current (HVDC) application. For example, the electric circuit 1 may be configured for a modular multilevel converter (MMC).

Features and advantages described in connection with the electric circuit may also apply for the method and vice versa.

Every feature described in connection with one embodiment can be combined with one or more features described in connection with another embodiment unless the embodiments are contradictory.

The accompanying figures are included to provide a further understanding. In the figures, elements of the same structure and/or functionality may be referenced by the same reference signs. It is to be understood that the embodiments shown in the figures are illustrative representations and are not necessarily drawn to scale.

In the Figures:
Figure 1 shows a schematic representation of an electric circuit according to an embodiment;
Figure 2 shows a schematic representation of an electric circuit according to an embodiment;
Figure 3 exemplarily illustrates a pulse pattern during a starting mode according to an embodiment of a method of operating an electric circuit; and
Figure 4 exemplarily illustrates a pulse pattern during a shutdown or failure mode according to an embodiment of a method of operating an electric circuit.

While the disclosure is amenable to various modifications and alternative forms, specifics thereof have been shown by way of example in the figures and will be described in detail. It should be understood, however, that the intention is not to limit the disclosure to the particular embodiments described. On the contrary, the intention is to cover all modifications, equivalents, and alternatives falling within the scope of the disclosure defined by the appended claims.

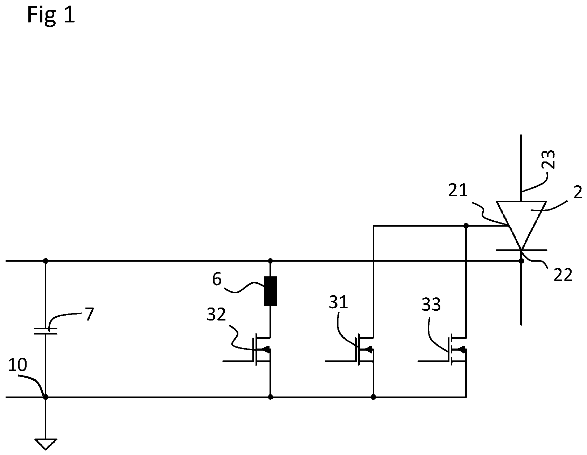

In the exemplary embodiment of Figure 1 an electric circuit 1 comprises a power thyristor device 2 wherein a gate 21 of the power thyristor device 2 is connected to an internal reference 10 of the electric circuit 1 via a first switch 31. A cathode 22 of the power thyristor device 2 is connected to the internal reference 10 of the electric circuit 1 via a second switch 32.

Thus, the gate 21 and the cathode 22 of the power thyristor device 2 are connected to the same internal reference 10 of the electric circuit 1 if the first switch 31 and the second switch 32 are in an electrically conductive on-state.

In the exemplary embodiment of Figure 1, the first switch 31 and the second switch 32 are normally-on semiconductor devices such as depletion mode n-channel MOSFETs.

In Figure 1, the internal reference 10 is at ground potential. However, this is not required. Rather, the internal reference may be electrically separated from ground.

The electric circuit 1 further comprises a capacitor unit 7. During regular operation of the electric circuit 1, the capacitor unit 7 may provide a current to switch off the power thyristor device 2 if a third switch 33 arranged in an off-channel line 53 is in its on-state.

The first switch 31 and the second switch 32, in contrast, are in their off-states during regular operation of the electric circuit 1.

During a starting mode, and/or during a shutdown or failure mode, however, the first switch 31 and the second switch 32 may be in a conductive on-state providing an electric connection between the cathode 22 and the gate 21 of the power thyristor device 2 to ensure a blocking capability of the power thyristor device during these operation modes.

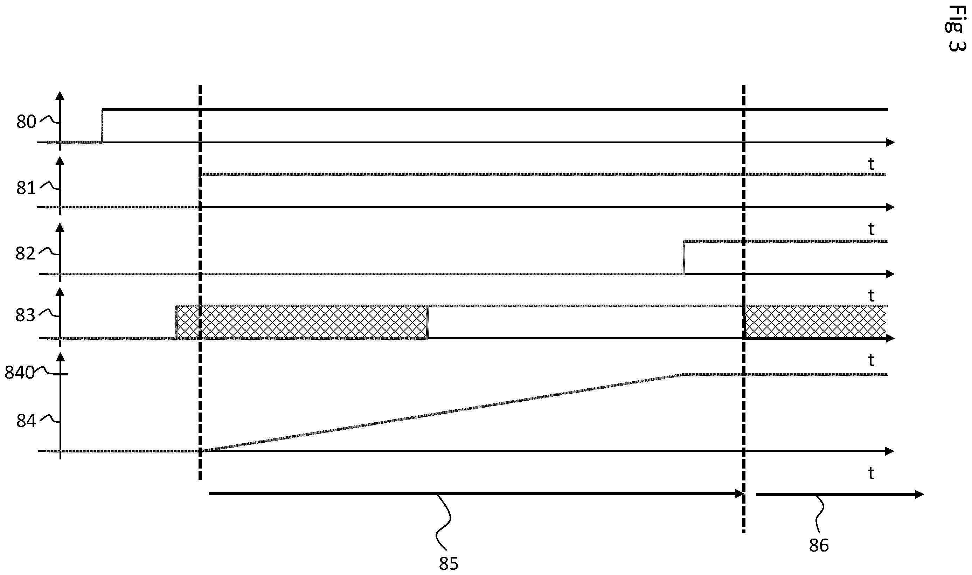

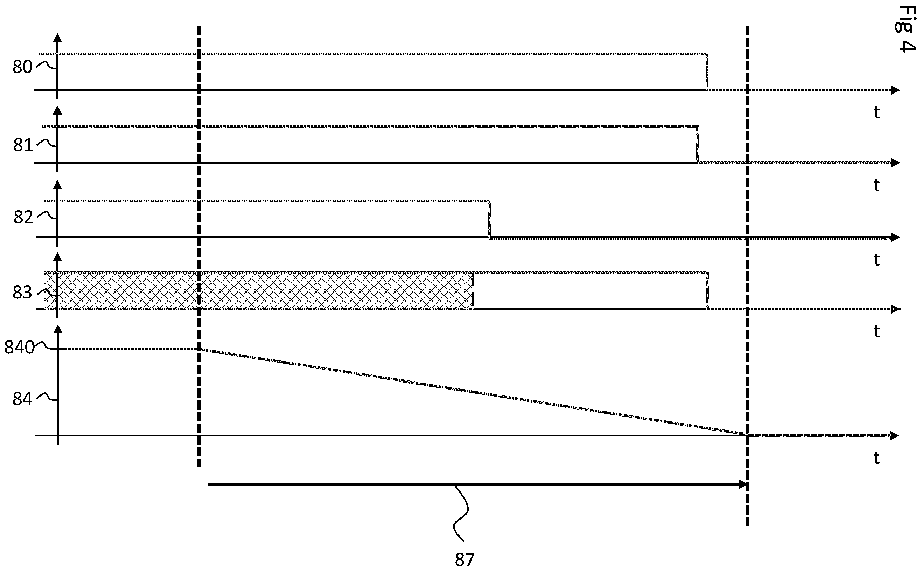

This will be described in more detail in connection with Figures 3 and 4.

The electric circuit 1 further comprises a resistor 6 arranged in a current path through the second switch between the cathode 22 and the internal reference 10 of the electric circuit 1.

For example, a resistance of the resistor 6 is in a range from 0.1 Ω to 20 Ω.

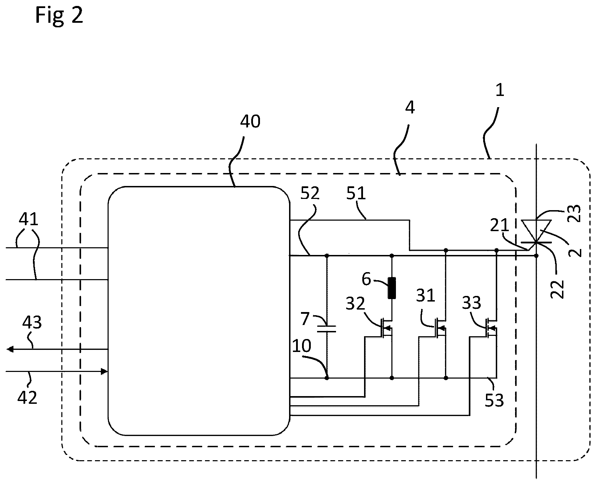

The description of Figure 1 also applies to Figure 2. Figure 2 further shows details of the electric circuit 1 which is configured as an integrated gate-commutated thyristor.

The electric circuit 1 comprises the power thyristor device 1 and a gate unit 4 with a gate control unit 40.

For example, the gate control unit 40 comprises one or more power supplies. Further, the gate control unit 40 may comprise a monitor and control logic and/or drivers and/or trigger and back porch circuits, for example. During operation of the electric circuit 1, the electric circuit 1 is externally connected via input power lines 41. Further, the gate control unit 40 is configured to receive an input signal 42 and to output an output signal 43.

A cathode line 52 connects the gate control unit 40 to the cathode 22 of the power thyristor device. A gate line 51 connects the gate control unit 40 to the gate 21 of the power thyristor device 2.

Further, the gate unit 4 comprises the first switch 31, the second switch 32, the third switch 33, the capacitor unit 7 as described in connection with Figure 1. In particular, the electric circuit is configured to be operable in different operation modes.

The third switch 33 is a normally-off semiconductor device. During regular operation of the electric circuit 1, the power thyristor device 2 can be switched off by applying a gate voltage to the gate of the third switch 33.

Figure 3 illustrates a pulse pattern during a starting mode of the electric circuit 1.

The figure schematically illustrates a gate unit power 80, a signal level at the second switch 81, a signal level at the first switch 82, a signal level of the off-channel 83, and a capacitor voltage 84 with a maximum voltage 840 as functions of time.

The starting mode 85 is illustrated as an arrow extending between the hatched lines. During the starting mode, the capacitor unit 9 is charged. Afterwards the electric circuit can be operated in its regular operation mode 86.

As Figure 3 illustrates, first the gate unit power 80 is activated to supply the gate control unit 40.

Afterwards, the second switch 32 is brought in its blocking state by a HIGH signal applied to its gate. As capacitor voltage 84 illustrates, the capacitor unit 9 is fully charged during the starting mode 85.

The off-channel 83 is turned on (HIGH signal) prior to, during or after the charging of the capacitor unit 7 is started but at least before IGCT went into operation (arrow 86). This is illustrated by the hatched area. A further hatched area illustrates that the power thyristor device 2 can be turned on directly at the beginning of the regular operation mode 86 if a corresponding signal is applied to the IGCT during the starting mode. For example, the signal may be received as an optical signal via a fibre. Then the off-channel 83 (third switch) will be turned off and a gate signal is applied. For example, a trigger current and a back porch current are applied to the gate of the power thyristor device 2.

After the charging of the capacitor unit 7, and off-channel 83 (third switch) is in its conducting mode by an applied HIGH signal, the first switch 31 is brought in its off-state (HIGH signal). Once the capacitor unit 7 has been fully charged, the electric circuit 1 is ready for regular operation where the power thyristor device 2 may be turned on and off by switching the third switch 33 into its conductive state, or any trigger or back porch current is applied by the gate control unit 40 to turn on or keep the power thyristor in on-state.

It goes without saying that the gate control unit 40 may fulfil further functions and/or provide further signals such as retriggering.

Figure 4 illustrates an example of a pulse pattern for a shutdown or failure mode of the electric circuit 1.

The shutdown 87 is illustrated as an arrow extending between two hatched lines.

During the shutdown or failure mode 87, the capacitor unit 7 is discharged as illustrated by capacitor voltage 84. At the beginning of the discharging process, the signal of the off-channel 83 may be HIGH or LOW. This is illustrated by the hatched area in Figure 4.

Once the capacitor voltage 84 has fallen to a certain value, the electric circuit 1 will not be able to maintain or to deliver a back porch current or to turn on the power thyristor device 2. The gate control unit 40 will not be able to react on input signals.

In case the gate 21 of the power thyristor device 2 is in its on-state by an applied signal to the gate 21, the gate control unit 4 will turn off the power thyristor device 2 by turning on the off-channel. Afterwards the first switch 31 is brought into its conducting on-state (LOW signal) to electrically connect the gate 21 of the power thyristor device 2 to the internal reference 10.

The second switch 32 switches into its conducting on-state (LOW signal), thereby providing an electrical short circuit between the cathode 22 and the internal reference 10. This happens before, during or slightly after power loss of the control logic. At this point the off-channel signal level 83 switches to the LOW level so that the third switch 33 is brought in its off-state.

Remaining charges in the capacitor unit 7 may be discharged via the second switch 32 and the resistor 6. The resistor 6 may also be omitted. For example, the discharge current may be limited by appling an appropriate signal to the gate of the second switch 32.

The different operation modes illustrate that the electric circuit 1 provides a reliable DC blocking and/or dV/dt robustness capability for all operation modes.

Further, the electric circuit 1 is fully black start capable, which is needed for various applications. In particular, the black start capability does not require any power or any kind of energy storage.

The electric circuit 1 may be configured for a HVDC application. For example, the electric circuit 1 may be configured for a modular multilevel converter.

The embodiments shown in the Figures 1 to 4 as stated represent exemplary embodiments of the improved electric circuit and the method; therefore, they do not constitute a complete list of all embodiments according to the improved electric circuit and method. Actual electric circuits and methods may vary from the embodiments shown in terms of arrangements, electric components, and signals for example.

### Reference Signs

- 1: electric circuit
- 10: internal reference
- 2: power thyristor device
- 21: gate
- 22: cathode
- 23: anode
- 31: first switch
- 32: second switch
- 33: third switch
- 4: gate unit
- 40: gate control unit
- 41: input power lines
- 42: input signal
- 43: output signal
- 51: gate line
- 52: cathode line
- 53: off-channel line
- 6: resistor
- 7: capacitor unit
- 80: gate unit power
- 81: signal level at second switch
- 82: signal level at first switch
- 83: off-channel signal level
- 84: capacitor voltage
- 840: maximum voltage
- 85: starting mode
- 86: regular mode
- 87: shutdown or failure mode

## Claims

1. An electric circuit (1) comprising a power thyristor (2) device (2), wherein
- a gate (21) of the power thyristor device (2) is connected to an internal reference (10) of the electric circuit (1) via a first switch (31); and
- a cathode (22) of the power thyristor device (2) is connected to the internal reference (10) of the electric circuit (1) via a second switch (32).

2. The electric circuit according to claim 1,
wherein the power thyristor device (2) is a gate-commutated thyristor.

3. The electric circuit according to claim 1 or 2,
wherein the first switch (31) and the second switch (32) are normally-on semiconductor devices.

4. The electric circuit according to any one of the preceding claims,
wherein the first switch (31) and the second switch (32) are depletion mode n-channel field effect transistors.

5. The electric circuit according to any one of the preceding claims,
wherein a resistor (6) configured to limit a discharge current is arranged in a current path through the second switch (32) between the cathode (22) and the internal reference (10).

6. The electric circuit according to any one of the preceding claims,
wherein the electric circuit (1) further comprises a gate control unit (40) configured to control the gate (21) of the power thyristor device (2), the first switch (31), and the second switch (32).

7. The electric circuit according to any one of the preceding claims,
wherein the electric circuit (1) is configured as an integrated gate-commutated thyristor.

8. The electric circuit according to any one of the preceding claims,
wherein the electric circuit (1) further comprises a capacitor unit (7) connected to the gate (21) via a third switch (33).

9. The electric circuit according to claim 8,
wherein the third switch (33) comprises a normally-off semiconductor device.

10. A method of operating an electric circuit according to claim 8 or 9, wherein the electric circuit (1) is operable in a plurality of operation modes.

11. The method according to claim 10,
wherein the electric circuit (1) is operated in a starting mode (85), wherein the first switch (31) is brought in an off-state after the capacitor unit (7) has been charged.

12. The method according to claim 11,
wherein the second switch (32) is brought in an off-state before the first switch (31) is brought in an off-state.

13. The method according to claim 11,
wherein the electric circuit (1) is operated in a shutdown or failure mode (87), wherein the first switch (31) and the second switch (32) are brought in an on-state at a time where the capacitor unit (7) is at least partly discharged.

14. The method according to claim 13,
wherein the first switch (31) is brought in the on-state prior to the second switch (32).
